# EUROPEAN PATENT APPLICATION

(11) **EP 4 641 641 A1**
(43) Date of publication of application: **29.10.2025**
(21) Application number: 23905228.5
(22) Date of filing: 18.07.2023
(51) Int. Cl.: H01L 29/78, H01L 29/06, H01L 21/336

(54) **VDMOS DEVICE, PREPARATION METHOD THEREFOR AND ELECTRICAL APPARATUS**

(30) Priority: 21.12.2022 CN 202223489208 U
(71) Applicant: BYD Company Limited, Shenzhen, Guangdong 518118 (CN); BYD Auto Industry Company Limited, Guangdong 518118 (CN)
(72) Inventor: ZHOU, Wei, Shenzhen, Guangdong 518118 (CN); LI, Yonghui, Shenzhen, Guangdong 518118 (CN); LI, Junqiao, Shenzhen, Guangdong 518118 (CN)
(74) Representative: Aldridge, Henry Alexander
(86) International application number: PCT/CN2023/107989
(87) International publication number: WO 2024/131047

(57) **Abstract**

Disclosed in the present application are a VDMOS device, a preparation method therefor and an electrical apparatus. The VDMOS device comprises: a substrate; an epitaxial layer, the epitaxial layer being arranged on one side of the substrate; a plurality of body regions arranged at intervals, the body regions being arranged on the side of the epitaxial layer away from the substrate; a plurality of source regions; a plurality of first gate oxide layers arranged at intervals, each first gate oxide layer being arranged in contact with two adjacent body regions, the first gate oxide layers covering at least part of the surface of the epitaxial layer away from the substrate, part of the surfaces of the body regions away from the substrate and part of the surfaces of the adjacent source regions away from the substrate, and the orthographic projections of two source regions on the substrate being respectively located within the ranges of the orthographic projections of two adjacent body regions on the substrate; a plurality of second gate oxide layers arranged at intervals, each second gate oxide layer covering part of the surface of a corresponding first gate oxide layer away from the substrate; a gate; a dielectric layer; and a metal layer, the metal layer being arranged in contact with the source regions, and the metal layer being arranged in contact with the first gate oxide layers and the second gate oxide layers.

## Description

### CROSS-REFERENCE TO RELATED APPLICATIONS

The present application claims the benefit of priority to Chinese Patent Application No. 202223489208.3 filed on December 21, 2022, which is incorporated herein in its entirety.

### FIELD

The present application relates to the technical field of semiconductor devices, in particular to a VDMOS device, a preparation method therefor, and an electrical apparatus.

### BACKGROUND

In power devices, MOSFET (metal-oxide-semiconductor field effect transistor) has the advantages of high input impedance, high switching speed stability and low on-resistance, and is the most concerned switching device. Compared with JFET (junction field effect transistor), MOSFET has very low gate current and high input resistance, which greatly simplifies the driving circuit. Compared with BJT (Bipolar Junction Transistor), MOSFET is majority carrier conductive and has no minority carrier implantation process, so it can operate at a higher frequency.

In MOSFETs, VDMOS devices (Vertical Conduction Double Scattering Metal Oxide Semiconductor devices) are currently developing faster power devices, which have unique characteristics such as high input impedance, low driving power, high switching speed, superior frequency characteristics, low noise and good thermal stability, strong radiation resistance and simple manufacturing process; VDMOS devices are widely used in various fields such as AC drive, variable frequency power supply, switching regulated power supply and other fields.

However, the current VDMOS devices have a single threshold voltage and low driving ability, which often leads to the problem that the devices do not meet the system requirements, and the cost of replacing devices is high and the verification cycle is long. Therefore, the current VDMOS devices still need to be improved.

### SUMMARY

In order to alleviate or solve at least one of the above-mentioned problems to a certain extent, in one aspect of the present application, the present application provides a VDMOS device. The VDMOS device includes: a substrate; an epitaxial layer, the epitaxial layer is arranged on a side of the substrate; a plurality of body regions arranged at intervals, the body regions are arranged on the side of the epitaxial layer away from the substrate, and the body regions extend from a side surface of the epitaxial layer to the inside of the epitaxial layer; a plurality of source regions, each of the body regions is arranged in contact with two source regions, the source regions are arranged on a side of the body region away from the substrate, the source regions extend from a side surface of the body region to the inside of the body region, and an orthographic projection of the body region on the substrate covers the orthographic projections of the two source regions in contact with the body region on the substrate; a plurality of first gate oxide layers arranged at intervals, the first gate oxide layer is arranged in contact with two adjacent body regions, the first gate oxide layer covers at least a portion of a surface of the epitaxial layer away from the substrate, a portion of the surface of the body region away from the substrate, and a portion of the surfaces of the two adjacent source regions away from the substrate, and orthographic projections of the two source regions on the substrate are respectively located within the range of the orthographic projections of the two adjacent body regions on the substrate; a plurality of second gate oxide layers arranged at intervals, each of the second gate oxide layers covers a portion of a surface of the corresponding first gate oxide layer away from the substrate, an orthographic projection of the second gate oxide layer on the substrate and the orthographic projection of one of the two source regions in contact with the same body region on the substrate have an overlapping region, and the orthographic projection of the second gate oxide layer on the substrate and an orthographic projection of the other source region on the substrate have no overlapping region; a gate, the gate covers a portion of a surface of the second gate oxide layer away from the substrate and a portion of a surface of the first gate oxide layer away from the substrate; a dielectric layer, and the dielectric layer covers a surface of the gate away from the substrate, a portion of a surface of the second gate oxide layer away from the substrate, and a portion of a surface of the first gate oxide layer away from the substrate; and a metal layer, the metal layer is arranged in contact with the source region, and the metal layer is arranged in contact with the first gate oxide layer and the second gate oxide layer. Therefore, the device has turn-on voltages with different thresholds, which can be adjusted according to different application scenarios or environments to meet users' requirements for devices of different specifications, improve driving capabilities, reduce costs of the device and expand the application range of products.

According to an embodiment of the present application, the gate includes a first sub-gate and a second sub-gate, the first sub-gate covers a portion of a surface of the first gate oxide layer away from the substrate, and the second sub-gate covers a portion of a surface of the second gate oxide layer away from the substrate. Therefore, the first sub-gate and the second sub-gate can respectively correspond to gate oxide layers having different thicknesses, thereby further improving the usage performance of the device.

According to an embodiment of the present application, the substrate is a first conductivity type substrate, the epitaxial layer is a first conductivity type epitaxial layer, the body region is a second conductivity type body region, and the source region is a first conductivity type source region. The first conductivity type is an electron conductivity type and the second conductivity type is a hole conductivity type, or the first conductivity type is a hole conductivity type and the second conductivity type is an electron conductivity type. Therefore, the device can have better overall performance.

According to an embodiment of the present application, the materials of the substrate and the epitaxial layer are independently silicon or silicon carbide.

According to an embodiment of the present application, the material of the first gate oxide layer and the material of the second gate oxide layer independently include at least one of silicon oxide and hafnium oxide. Therefore, the first gate oxide layer has good insulation and high dielectric constant, which is beneficial to improving the breakdown voltage of the device and thus improving the reliability of the device.

According to an embodiment of the present application, the thickness of the first gate oxide layer is 300 Å to 600 Å. Therefore, the first gate oxide layer has a suitable thickness, and when the voltage applied to the gate exceeds a certain value, the device is turned on.

According to an embodiment of the present application, the thickness of the second gate oxide layer is 300 Å to 800 Å. A first gate oxide layer is arranged below the second gate oxide layer, and a higher voltage needs to be applied to the gate, so that the channel corresponding to the portion is turned on, and the on-resistance of the device changes, thus changing the device specification.

According to an embodiment of the present application, the thickness of the gate is 5000 Å to 7000 Å.

According to an embodiment of the present application, the material of the dielectric layer includes at least one of polyimide or borophosphosilicate glass.

In another aspect of the present application, the present application provides a method for preparing a VDMOS device. The method includes the following steps: a substrate is provided, and an epitaxial layer is arranged on a side of the substrate. A first oxide layer and a silicon nitride layer are sequentially formed on a side of the epitaxial layer away from the substrate. The silicon nitride layer is etched to expose a portion of a surface of the first oxide layer to obtain an etched silicon nitride layer. A second oxide layer is formed on an exposed surface of the first oxide layer, and the etched silicon nitride layer is removed. A gate is formed, and the gate covers a portion of a surface of the first oxide layer away from the substrate and a portion of a surface of the second oxide layer away from the substrate. Implantation and drive-in are performed on the body region, and implantation and drive-in are performed on the source region to obtain a plurality of body regions arranged at intervals and a plurality of source regions arranged at intervals. The body regions are arranged on the side of the epitaxial layer away from the substrate, and the body regions extend from a side surface of the epitaxial layer to the inside of the epitaxial layer. Each of the body regions is arranged in contact with two source regions, the source regions extend from a side surface of the body region to the inside of the body region, and an orthographic projection of the body region on the substrate covers the orthographic projections of the two source regions in contact with the body region on the substrate. A dielectric layer and a contact hole are formed. The contact hole penetrates the dielectric layer, the first oxide layer, and the second oxide layer to obtain a plurality of first gate oxide layers arranged at intervals and a plurality of second gate oxide layers arranged at intervals. The dielectric layer covers a surface of the gate away from the substrate, a portion of a surface of the first gate oxide layer away from the substrate, and a portion of a surface of the second gate oxide layer away from the substrate. The first gate oxide layer is arranged in contact with two adjacent body regions. The first gate oxide layer covers at least a portion of a surface of the epitaxial layer away from the substrate, a portion of a surface of the body region away from the substrate, and a portion of surfaces of the two adjacent source regions away from the substrate. The orthographic projections of the two source regions on the substrate are respectively located within the range of the orthographic projections of the two adjacent body regions on the substrate. Each of the second gate oxide layers covers a portion of a surface of the corresponding first gate oxide layer away from the substrate, an orthographic projection of the second gate oxide layer on the substrate and the orthographic projection of one of the two source regions in contact with the same body region on the substrate have an overlapping region, and the orthographic projection of the second gate oxide layer on the substrate and an orthographic projection of the other source region on the substrate have no overlapping region. A metal layer is formed. The metal layer fills the contact hole and is arranged in contact with the source region. Therefore, the VDMOS device prepared by the above method has turn-on voltages with different thresholds, which can be adjusted according to different application scenarios or environments to meet users' requirements for devices of different specifications, improve driving capabilities, reduce costs of the device and expand the application range of products.

According to an embodiment of the present application, the first oxide layer and/or the second oxide layer are formed by thermal oxidation.

According to an embodiment of the present application, the silicon nitride layer is formed by low pressure chemical vapor deposition.

According to an embodiment of the present application, etching the silicon nitride layer includes: a photoresist layer is formed on a portion of a surface of the silicon nitride layer away from the substrate. A portion of the silicon nitride layer is removed by a wet etching process. The photoresist layer is removed.

According to an embodiment of the present application, after removing the photoresist layer, the method further includes performing an annealing treatment on the device. The annealing treatment is performed in a H₂ atmosphere, and the temperature of the annealing treatment is 900°C to 1000°C.

According to an embodiment of the present application, forming the gate includes: an original gate is formed, and the original gate covers a portion of a surface of the first oxide layer away from the substrate and a surface of the second oxide layer away from the substrate. The original gate is etched to expose a portion of a surface of the second oxide layer away from the substrate.

In another aspect of the present application, the present application provides an electrical apparatus. According to an embodiment of the present application, the electrical apparatus includes: the above VDMOS device or a VDMOS device prepared by the above method. Therefore, the electrical apparatus has all the features and advantages of the above VDMOS device, and will not be described herein. In general, the electrical apparatus can realize the conversion of different specifications and adapt to different application scenarios.

### BRIEF DESCRIPTION OF THE DRAWINGS

The above and/or additional aspects and advantages of the present application will become apparent and readily understood from the description of embodiments taken in conjunction with the following drawings.
FIG. 1 shows a schematic structural diagram of a VDMOS device according to an embodiment of the present application;
FIG. 2 shows a schematic structural diagram of a VDMOS device according to another embodiment of the present application;
FIG. 3 is a flowchart showing a partial method for preparing a VDMOS device according to an embodiment of the present application;
FIG. 4 is a flowchart showing a partial method for preparing a VDMOS device according to an embodiment of the present application;
FIG. 5 is a flowchart showing a partial method for preparing a VDMOS device according to an embodiment of the present application.

### Description of reference numbers:

100: substrate; 200: epitaxial layer; 300: body region; 310: first channel; 320: second channel; 330: third channel; 340: fourth channel; 400: source region; 500: first gate oxide layer; 500': first oxide layer; 600: second gate oxide layer; 600':second oxide layer; 700: gate; 710: first sub-gate; 720: second sub-gate; 800: dielectric layer; 900: metal layer; 10: silicon nitride layer; 10': etched silicon nitride layer; 20': photoresist layer; 1: contact hole.

### DETAILED DESCRIPTION

Embodiments of the present application are described in detail below, examples of which are shown in the accompanying drawings, wherein the same or similar reference numerals denote the same or similar elements or elements having the same or similar functions throughout. The embodiments described below with reference to the accompanying drawings are exemplary and are merely used to explain the present application, and should not be construed as limiting the present application.

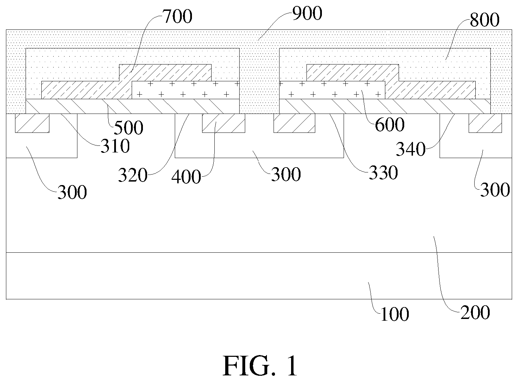

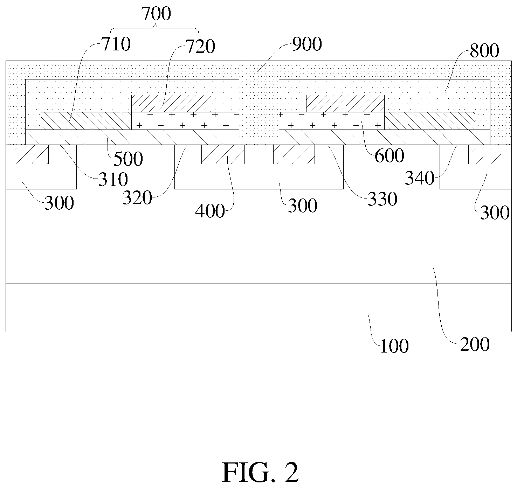

In one aspect of the present application, the present application provides a VDMOS device. According to an embodiment of the present application, referring to FIGS. 1 and 2, a VDMOS device can include a substrate 100, an epitaxial layer 200, a plurality of body regions 300 arranged at intervals, a plurality of source regions 400, a plurality of first gate oxide layers 500 arranged at intervals, a plurality of second gate oxide layers 600 arranged at intervals, a gate 700, a dielectric layer 800, and a metal layer 900. The epitaxial layer 200 is arranged on a side of the substrate 100. The body regions 300 are arranged on the side of the epitaxial layer 200 away from the substrate 100, and the body regions 300 extend from a side surface of the epitaxial layer 200 to the inside of the epitaxial layer 200. Each of the body regions 300 is arranged in contact with two source regions 400, the source regions 400 are arranged on a side of the body region 300 away from the substrate 100, the source regions 400 extend from a side surface of the body region 300 to the inside of the body region 300, and an orthographic projection of the body region 300 on the substrate 100 covers the orthographic projections of the two source regions 400 in contact with the body region 300 on the substrate 100. The first gate oxide layer 500 is arranged in contact with two adjacent body regions 300. The first gate oxide layer 500 covers at least a portion of the surface of the epitaxial layer 200 away from the substrate 100, a portion of the surface of the body region 300 away from the substrate 100, and a portion of the surfaces of the two adjacent source regions 400 away from the substrate 100. The orthographic projections of the two source regions 400 on the substrate 100 are respectively located within the range of the orthographic projections of the two adjacent body regions 300 on the substrate 100. Each of the second gate oxide layers 600 covers a portion of the surface of the corresponding first gate oxide layer 500 away from the substrate 100. The orthographic projection of the second gate oxide layer 600 on the substrate 100 and the orthographic projection of one of the two source regions 400 in contact with the same body region 300 on the substrate 100 have an overlapping region, and the orthographic projection of the second gate oxide layer 600 on the substrate 100 and the orthographic projection of the other source region 400 on the substrate 100 have no overlapping region. The gate 700 covers a portion of a surface of the second gate oxide layer 600 away from the substrate 100 and a portion of the surface of the first gate oxide layer 500 away from the substrate 100. The dielectric layer 800 covers a surface of the gate 700 away from the substrate 100, a portion of a surface of the second gate oxide layer 600 away from the substrate 100, and a portion of the surface of the first gate oxide layer 500 away from the substrate 100. The metal layer 900 is arranged in contact with the source region 400, and the metal layer 900 is arranged in contact with the first gate oxide layer 500 and the second gate oxide layer 600. Therefore, the device has turn-on voltages with different thresholds, which can be adjusted according to different application scenarios or environments to meet users' requirements for devices of different specifications, improve driving capabilities, and expand the application range of the product. The same device can realize the functions of devices with different specifications, which is equivalent to reducing costs of the device to a certain extent.

The principle that the VDMOS device provided in the present application can realize different threshold voltage specifications is described in detail below.

When the VDMOS device is turned on, a relatively thin channel is formed on the surface of the first gate oxide layer in contact with the body region, so that electrons can pass through and a closed circuit is formed.

Referring to FIGS. 1 and 2, a first channel 310 and a fourth channel 340 have the gate oxide layer with the same thickness (both of the first channel 310 and the fourth channel 340 correspond only to the first gate oxide layer 500, and the thicknesses of the gate oxide layers of the first channel 310 and the fourth channel 340 are the thickness T1 of the first gate oxide layer 500) and have the body region with the same concentration, and have the same threshold voltage, which is assumed to be V1. A second channel 320 and a third channel 330 have the gate oxide layer with the same thickness (the first gate oxide layer 500 and the second gate oxide layer 600 are simultaneously arranged above the second channel 320 and the third channel 330, therefore, the thicknesses of the gate oxide layers of the second channel 320 and the third channel 330 are the sum T2 of the thicknesses of the first gate oxide layer 500 and the second gate oxide layer 600) and have the body region with the same concentration, and have the same threshold voltage, which is assumed to be V2. T2 > T1, therefore, V2 > V1.

In the terminal application, there are the following situations: assuming that the voltage applied to the gate is less than V1, the device is turned off; when the voltage applied to the gate is greater than V1 but less than V2, the first channel 310 and the fourth channel 340 are turned on, and the device is turned on, but part of the channels (the second channel 320 and the third channel 330) are not turned on because the voltage applied to the gate is less than V2; and when the voltage applied to the gate is greater than V2, all channels are turned on, the number of conductive cells increases, and the on-resistance of the device changes, thus changing the specifications of the device. In this way, high-voltage VDMOS devices with various threshold voltage specifications can be formed, which is convenient to modify and adjust the system when the device is applied, thus expanding the application range of the device.

According to an embodiment of the present application, the material of the first gate oxide layer 500 and the material of the second gate oxide layer 600 may independently include at least one of silicon oxide and hafnium oxide. According to an embodiment of the present application, the material of the first gate oxide layer 500 and the material of the second gate oxide layer 600 may be independently silicon oxide or hafnium oxide. The gate oxide layer made of the above material has good insulation effect and high dielectric constant, which can effectively avoid the generation of leakage current, and can improve the breakdown resistance of the device, so that the device has higher reliability.

According to an embodiment of the present application, the thickness of the first gate oxide layer 500 may be 300 Å to 600 Å, for example, the thickness of the first gate oxide layer 500 may be 300 Å, 350 Å, 400 Å, 450 Å, 500 Å, 550 Å, 600 Å, etc. Therefore, the first gate oxide layer has a suitable thickness, can play an effective insulating role, so that the first channel and the fourth channel are turned on at a certain gate voltage.

According to an embodiment of the present application, the thickness of the second gate oxide layer 600 may be 300 Å to 800 Å, for example, the thickness of the second gate oxide layer 600 may be 300 Å, 400 Å, 500 Å, 600 Å, 700 Å, 800 Å, etc. Therefore, the second gate oxide layer has a suitable thickness so that the second channel and the third channel can be turned on at a higher gate voltage, thereby realizing the transition of device specifications.

According to an embodiment of the present application, referring to FIG. 2, the gate 700 may include a first sub-gate 710 and a second sub-gate 720, the first sub-gate 710 covers a portion of the surface of the first gate oxide layer 500 away from the substrate 100, and the second sub-gate 720 covers a portion of a surface of the second gate oxide layer 600 away from the substrate 100. Therefore, voltages may be applied to the first sub-gate 710 and the second sub-gate 720, respectively, thus adjusting the ON-OFF of the first channel 310, the fourth channel 340, the second channel 320, and the third channel 330.

According to an embodiment of the present application, the substrate 100 may be a first conductivity type substrate, the epitaxial layer 200 may be a first conductivity type epitaxial layer, the body region 300 may be a second conductivity type body region, and the source region 400 may be a first conductivity type source region. The first conductivity type is an electron conductivity type and the second conductivity type is a hole conductivity type, or the first conductivity type is a hole conductivity type and the second conductivity type is an electron conductivity type.

According to some embodiments of the present application, the substrate 100 may be a heavily doped N-type substrate, the epitaxial layer 200 may be a lightly doped N-type epitaxial layer, the body region is a lightly doped P-type body region, and the source region 400 is a heavily doped N-type source region.

According to other embodiments of the present application, the substrate 100 may be a heavily doped P-type substrate, the epitaxial layer 200 may be a lightly doped P-type epitaxial layer, the body region is a lightly doped N-type body region, and the source region 400 is a heavily doped P-type source region.

According to some embodiments of the present application, the materials of the substrate 100 and the epitaxial layer 200 may be independently silicon or silicon carbide. Therefore, it is beneficial to further improve the overall performance of the device.

According to an embodiment of the present application, the material of the gate 700 may be polysilicon.

According to an embodiment of the present application, the thickness of the gate 700 may be 5000 Å to 7000 Å, for example, the thickness of the gate 700 may be 5000 Å, 5500 Å, 6000 Å, 6500 Å, 7000 Å, etc.

According to an embodiment of the present application, the material of the dielectric layer 800 may include at least one of polyimide or borophosphosilicate glass. According to an embodiment of the present application, the material of the dielectric layer 800 may be polyimide or borophosphosilicate glass (BPSG), and thus, the dielectric layer has good insulating properties, which is beneficial to further improve the overall performance of the device.

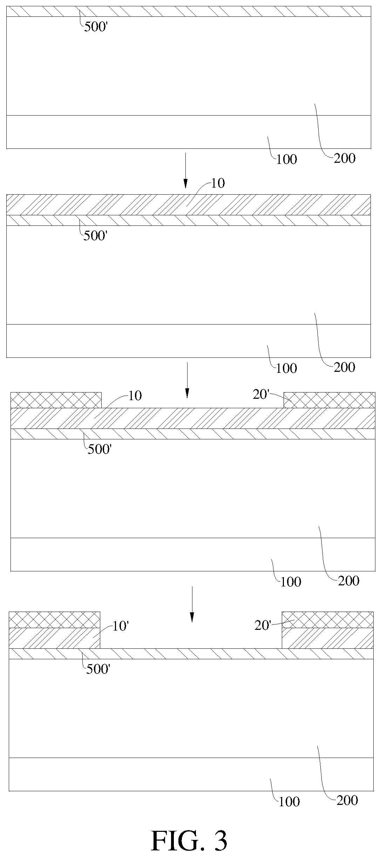

In another aspect of the present application, the present application provides a method for preparing a VDMOS device. According to some embodiments of the present application, referring to FIGS. 3 to 5, a method for preparing a VDMOS device may include the following steps:
S100: a substrate is provided.

Referring to FIG. 3, an epitaxial layer 200 is arranged on a side of the substrate 100.

S200: a first oxide layer 500' and a silicon nitride layer 10 are sequentially formed on a side of the epitaxial layer 200 away from the substrate 100.

Referring to FIG. 3, a first oxide layer 500' is formed on a surface of the epitaxial layer 200 away from the substrate 100, and a silicon nitride layer 10 is formed on a surface of the first oxide layer 500' away from the substrate 100.

According to some embodiments of the present application, the first oxide layer 500' is formed by thermal oxidation.

According to some embodiments of the present application, the silicon nitride layer 10 is formed by low pressure chemical vapor deposition.

S300: the silicon nitride layer is etched to expose a portion of a surface of the first oxide layer 500' to obtain an etched silicon nitride layer 10'.

According to some embodiments of the present application, referring to FIG. 3, etching the silicon nitride layer may include the following steps: a photoresist layer 20' is formed on a portion of the surface of the silicon nitride layer 10 away from the substrate 100. A portion of the silicon nitride layer 10 is removed by a wet etching process to obtain an etched silicon nitride layer 10'. The photoresist layer 20' is removed.

According to an embodiment of the present application, after removing the photoresist layer, the method may further include performing an annealing treatment on the device. The annealing treatment may be performed in a H₂ atmosphere, and the temperature of the annealing treatment may be 900°C to 1000°C, for example, the temperature of the annealing treatment may be 900 °C, 920 °C, 950 °C, 970 °C, 1000 °C, etc.

S400: a second oxide layer 600' is formed on an exposed surface of the first oxide layer 500', and the etched silicon nitride layer 10' is removed.

According to an embodiment of the present application, the second oxide layer 600' is formed by thermal oxidation.

S500: a gate 700 is formed.

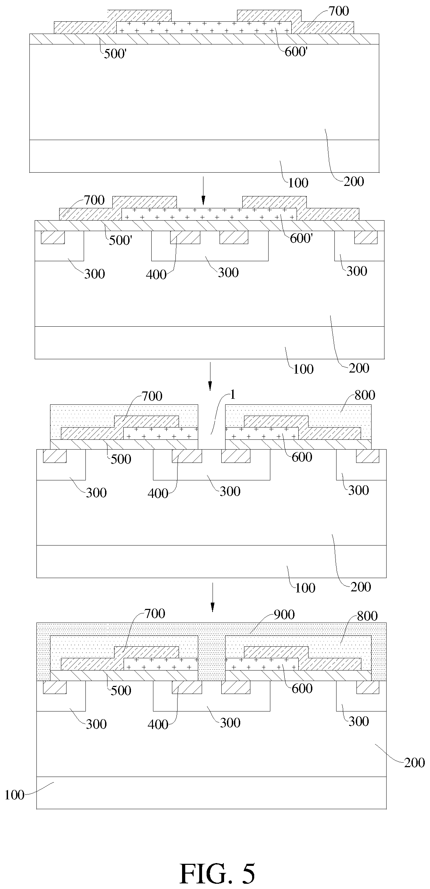

According to some embodiments of the present application, referring to FIG. 5, the gate covers a portion of the surface of the first oxide layer 500' away from the substrate 100 and a portion of a surface of the second oxide layer 600' away from the substrate 100.

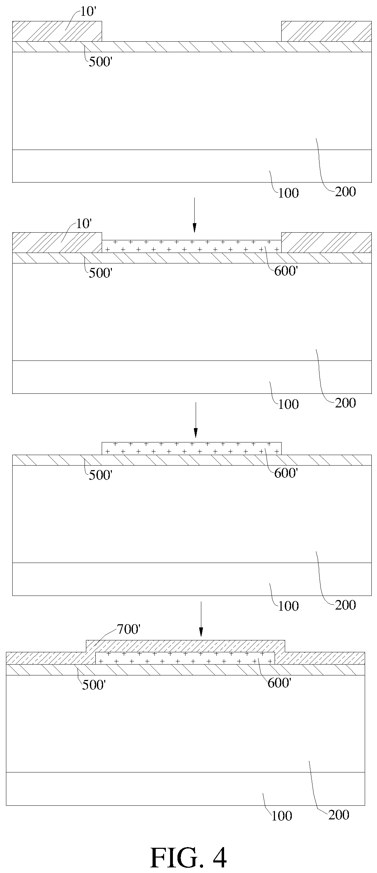

According to some embodiments of the present application, referring to FIGS. 4 and 5, forming a gate can include: an original gate 700' is formed, and the original gate 700' covers a surface of the first oxide layer 500' away from the substrate 100 and a surface of the second oxide layer 600' away from the substrate. The original gate 700' is etched to expose a portion of a surface of the second oxide layer 600' away from the substrate.

S600: implantation and drive-in are performed on the body region, and implantation and drive-in are performed on the source region to obtain a plurality of body regions arranged at intervals and a plurality of source regions arranged at intervals.

According to an embodiment of the present application, referring to FIG. 5, body regions 300 are arranged on the side of the epitaxial layer 200 away from the substrate 100, and the body regions 300 extend from a side surface of the epitaxial layer 200 to the inside of the epitaxial layer 200. Each of the body regions 300 is arranged in contact with two source regions 400, the source regions 400 extend from a side surface of the body region 300 to the inside of the body region 300, and an orthographic projection of the body region 300 on the substrate 100 covers the orthographic projections of the two source regions 400 in contact with the body region 300 on the substrate 100.

S700: a dielectric layer and a contact hole are formed.

Referring to FIG. 5, a dielectric layer 800 and a contact hole 1 are formed. The contact hole penetrates the dielectric layer 800, the first oxide layer 500', and the second oxide layer 600' to obtain a plurality of first gate oxide layers 500 arranged at intervals and a plurality of second gate oxide layers 600 arranged at intervals. The dielectric layer 800 covers a surface of the gate 700 away from the substrate 100, a portion of the surface of the first gate oxide layer 500 away from the substrate 100, and a portion of a surface of the second gate oxide layer 600 away from the substrate 100. The first gate oxide layer 500 is arranged in contact with two adjacent body regions 300. The first gate oxide layer 500 covers at least a portion of the surface of the epitaxial layer 200 away from the substrate 100, a portion of the surface of the body region 300 away from the substrate 100, and a portion of the surfaces of the two adjacent source regions 400 away from the substrate 100. The orthographic projections of the two source regions 400 on the substrate 100 are respectively located within the range of the orthographic projections of the two adjacent body regions 300 on the substrate 100.

S800: a metal layer is formed.

According to an embodiment of the present application, referring to FIG. 5, the metal layer 900 fills the contact hole 1 and is arranged in contact with the source region 400.

Hereinafter, according to an embodiment of the present application, a process for preparing a VDMOS device is described.

According to an embodiment of the present application, referring to FIG. 3, a lightly doped N-type epitaxial layer 200 is formed on a side of a heavily doped N-type substrate 100, and a first oxide layer 500' is grown on the surface of the N-type epitaxial layer 200 away from the substrate 100 by thermal oxidation, with a thickness of 300 Å to 600 Å, and the specific thickness can be determined according to the specifications of the device. Thereafter, a silicon nitride layer 10 is deposited on the surface of the first oxide layer 500' by a low pressure chemical vapor deposition (LPCVD), which may have a thickness of 800 Å to 1200 Å. A photoresist layer 20' is formed on a portion of the surface of the silicon nitride layer 10. Under the barrier of the photoresist layer 20', a portion of the silicon nitride layer is removed by a wet etching process to form an etched silicon nitride layer 10'. By the wet etching process, the exposed silicon nitride can be effectively removed and the first oxide layer 500' below the silicon nitride layer can be avoided from being damaged.

According to an embodiment of the present application, referring to FIG. 4, after forming the etched silicon nitride layer 10', the photoresist layer 20' is removed, and the surface is cleaned, the device can be annealed in a temperature range of 900 °C to 1000 °C using a furnace tube in a H₂ atmosphere, and the portion of the surface of the first oxide layer 500' that may be damaged by wet etching of silicon nitride can be repaired by annealing. Under the barrier of the etched silicon nitride layer 10', the second thermal oxidation treatment is performed, and the silicon nitride has a good effect of isolating oxygen, so that the oxide layer does not grow under the barrier of the silicon nitride, therefore the second oxide layer 600' is formed on a portion of the surface of the first oxide layer 500'. The thickness of the oxide layer of the second growth can be the same as the thickness of the oxide layer of the first growth, or can be different, depending on the design specifications of the device, for example, the thickness of the second oxide layer 600' can be 300 Å to 800 Å. Thereafter, the etched silicon nitride layer 10' is removed by wet etching. An original gate 700', made of polysilicon and having a thickness of 5000 Å to 7000 Å, is deposited, and the original gate 700' covers a surface of the second oxide layer 600' away from the substrate 100 and a portion of the surface of the first oxide layer 500'.

According to an embodiment of the present application, referring to FIG. 5, the original gate 700' is etched, and the gate 700 can be formed by photolithography, chemical etching or the like. Implantation (i.e. ion doping) and drive-in (i.e. high temperature annealing) are performed on the body region of the device, and implantation and drive-in are performed on the source region to obtain a lightly doped P-type body region 300 and a heavily doped N-type source region 400. Thereafter, a dielectric layer 800 is formed, a contact hole is formed (through which the metal layer 900 is in contact with the source region 400), and the metal layer 900 is fabricated to obtain the VDMOS device shown in FIG. 1.

The VDMOS device prepared by the above method has turn-on voltages with different thresholds, which can be adjusted according to different application scenarios or environments to meet users' requirements for devices of different specifications, improve driving capabilities, reduce costs of the device and expand the application range of products.

In another aspect of the present application, the present application provides an electrical apparatus. According to an embodiment of the present application, the electrical apparatus can include the above VDMOS device or a VDMOS device prepared by the above method, and thus, the electrical apparatus has all the features and advantages of the above VDMOS device, and will not be described herein. According to some embodiments of the present application, the electrical apparatus can be a lighting apparatus, a communication apparatus, a medical device, or the like.

In the description of the present application, the orientation or positional relationship indicated by the terms "above", "below" and the like is based on the orientation or positional relationship shown in the drawings, and is only for convenience of description of the present application and does not require that the present application must be constructed and operated in a specific orientation, and thus cannot be understood as limiting the present application.

In the description of the present specification, a description with reference to the terms "one embodiment", "another embodiment", "some embodiments", "some specific embodiments", "other specific embodiments" and the like means that a specific feature, structure, material, or characteristic described in connection with the embodiment is included in at least one embodiment of the present application. In the present specification, schematic expressions of the above-described terms are not necessarily directed to the same embodiments or examples. Moreover, the specific features, structures, materials, or features described may be combined in any one or more embodiments or examples in a suitable manner. Furthermore, a person skilled in the art can integrate and combine different embodiments or examples described in this specification and features of different embodiments or examples without contradicting each other. In addition, it should be noted that in the present specification, the terms "first" and "second" are used for descriptive purposes only, and cannot be understood as indicating or implicitly indicating relative importance or implicitly indicating the number of indicated technical features.

Although the embodiments of the present application have been shown and described above, it is to be understood that the above embodiments are exemplary and should not be understood as limitations of the present application, and a person skilled in the art can make changes, modifications, substitutions and modifications to the above embodiments within the scope of the present application.

## Claims

1. A VDMOS device, comprising:
a substrate;
an epitaxial layer, the epitaxial layer being arranged on a side of the substrate;
a plurality of body regions arranged at intervals, the body regions being arranged on the side of the epitaxial layer away from the substrate, and the body regions extending from a side surface of the epitaxial layer to the inside of the epitaxial layer;
a plurality of source regions, each of the body regions being arranged in contact with two source regions, the source regions being arranged on a side of the body region away from the substrate, the source regions extending from a side surface of the body region to the inside of the body region, and an orthographic projection of the body region on the substrate covering orthographic projections of two source regions in contact with the body region on the substrate;
a plurality of first gate oxide layers arranged at intervals, the first gate oxide layer being arranged in contact with two adjacent body regions, the first gate oxide layer covering at least a portion of a surface of the epitaxial layer away from the substrate, a portion of a surface of the body region away from the substrate, and a portion of surfaces of the two adjacent source regions away from the substrate, wherein orthographic projections of the two source regions on the substrate being respectively located within the range of the orthographic projections of the two adjacent body regions on the substrate;
a plurality of second gate oxide layers arranged at intervals, each of the second gate oxide layers covering a portion of a surface of the corresponding first gate oxide layer away from the substrate, an orthographic projection of the second gate oxide layer on the substrate and an orthographic projection of one of the two source regions in contact with the same body region on the substrate having an overlapping region, and the orthographic projection of the second gate oxide layer on the substrate and an orthographic projection of the other source region on the substrate having no overlapping region;
a gate, the gate covering a portion of a surface of the second gate oxide layer away from the substrate and a portion of a surface of the first gate oxide layer away from the substrate;
a dielectric layer, and the dielectric layer covering a surface of the gate away from the substrate, a portion of a surface of the second gate oxide layer away from the substrate, and a portion of a surface of the first gate oxide layer away from the substrate;
a metal layer, the metal layer being arranged in contact with the source region, and the metal layer being arranged in contact with the first gate oxide layer and the second gate oxide layer.

2. The VDMOS device according to claim 1, wherein the gate comprises a first sub-gate and a second sub-gate, the first sub-gate covers a portion of a surface of the first gate oxide layer away from the substrate, and the second sub-gate covers a portion of a surface of the second gate oxide layer away from the substrate.

3. The VDMOS device according to claim 1 or 2, wherein the substrate is a first conductivity type substrate, the epitaxial layer is a first conductivity type epitaxial layer, the body region is a second conductivity type body region, and the source region is a first conductivity type source region,
wherein the first conductivity type is an electron conductivity type and the second conductivity type is a hole conductivity type,
or the first conductivity type is a hole conductivity type and the second conductivity type is an electron conductivity type.

4. The VDMOS device according to any one of claims 1 to 3, wherein materials of the substrate and the epitaxial layer are independently silicon or silicon carbide.

5. The VDMOS device according to any one of claims 1 to 4, wherein a material of the first gate oxide layer and a material of the second gate oxide layer independently comprise at least one of silicon oxide and hafnium oxide.

6. The VDMOS device according to any one of claims 1 to 5, wherein a thickness of the first gate oxide layer is 300 Å to 600 Å.

7. The VDMOS device according to any one of claims 1 to 6, wherein a thickness of the second gate oxide layer is 300 Å to 800 Å.

8. The VDMOS device according to any one of claims 1 to 7, wherein a thickness of the gate is 5000 Å to 7000 Å.

9. The VDMOS device according to any one of claims 1 to 8, wherein a material of the dielectric layer comprises at least one of polyimide or borophosphosilicate glass.

10. A method for preparing a VDMOS device, comprising:
providing a substrate, and an epitaxial layer being arranged on a side of the substrate;
sequentially forming a first oxide layer and a silicon nitride layer on a side of the epitaxial layer away from the substrate;
etching the silicon nitride layer to expose a portion of a surface of the first oxide layer to obtain an etched silicon nitride layer;
forming a second oxide layer on an exposed surface of the first oxide layer, and removing the etched silicon nitride layer;
forming a gate, and the gate covering a portion of a surface of the first oxide layer away from the substrate and a portion of a surface of the second oxide layer away from the substrate;
performing implantation and drive-in on a body region, and performing implantation and drive-in on a source region to obtain a plurality of body regions arranged at intervals and a plurality of source regions arranged at intervals, the body regions being arranged on the side of the epitaxial layer away from the substrate, and the body regions extending from a side surface of the epitaxial layer to the inside of the epitaxial layer, each of the body regions being arranged in contact with two source regions, the source regions extending from a side surface of the body region to the inside of the body region, and an orthographic projection of the body region on the substrate covering orthographic projections of the two source regions in contact with the body region on the substrate;
forming a dielectric layer and a contact hole, the contact hole penetrating the dielectric layer, the first oxide layer, and the second oxide layer to obtain a plurality of first gate oxide layers arranged at intervals and a plurality of second gate oxide layers arranged at intervals, the dielectric layer covering a surface of the gate away from the substrate, a portion of a surface of the first gate oxide layer away from the substrate, and a portion of a surface of the second gate oxide layer away from the substrate, the first gate oxide layer being arranged in contact with two adjacent body regions, the first gate oxide layer covering at least a portion of a surface of the epitaxial layer away from the substrate, a portion of a surface of the body region away from the substrate, and a portion of surfaces of the two adjacent source regions away from the substrate, wherein orthographic projections of the two source regions on the substrate being respectively located within the range of orthographic projections of the two adjacent body regions on the substrate; each of the second gate oxide layers covering a portion of a surface of the corresponding first gate oxide layer away from the substrate, an orthographic projection of the second gate oxide layer on the substrate and an orthographic projection of one of the two source regions in contact with the same body region on the substrate having an overlapping region, and the orthographic projection of the second gate oxide layer on the substrate and an orthographic projection of the other source region on the substrate having no overlapping region;
forming a metal layer, and the metal layer filling the contact hole and being arranged in contact with the source region.

11. The method according to claim 10, wherein the first oxide layer and/or the second oxide layer are formed by thermal oxidation.

12. The method according to claim 10 or 11, wherein the silicon nitride layer is formed by low pressure chemical vapor deposition.

13. The method according to any one of claims 10 to 12, wherein etching the silicon nitride layer comprises:
forming a photoresist layer on a portion of a surface of the silicon nitride layer away from the substrate;
removing a portion of the silicon nitride layer by a wet etching process;
removing the photoresist layer.

14. The method according to claim 13, wherein after removing the photoresist layer, the method further comprises performing an annealing treatment on the device, the annealing treatment is performed in a H2 atmosphere, and the temperature of the annealing treatment is 900°C to 1000°C.

15. The method according to any one of claims 10 to 14, wherein forming the gate comprises:
forming an original gate, and the original gate covering a portion of a surface of the first oxide layer away from the substrate and a surface of the second oxide layer away from the substrate;
etching the original gate to expose a portion of a surface of the second oxide layer away from the substrate.

16. An electrical apparatus, comprising: a VDMOS device according to any one of claims 1 to 9 or a VDMOS device prepared by the method according to any one of claims 10 to 15.
